# EUROPEAN PATENT APPLICATION

(11) **EP 2 863 256 A1**
(43) Date of publication of application: **22.04.2015**
(21) Application number: 14188524.4
(22) Date of filing: 10.10.2014
(51) Int. Cl.: G02F 1/1335, G06F 1/16, H04M 1/02

(54) **Ito thin film for a terminal apparatus**

(30) Priority: 18.10.2013 CN 201310492710
(71) Applicant: Xiaomi Inc., Beijing 100085 (CN)
(72) Inventor: Gao, Yuan, Haidian District, (CN); Han, Gaocai, Haidian District, (CN); Jin, Hongzhi, Haidian District, (CN)
(74) Representative: Hanna, Peter William Derek

(57) **Abstract**

The present disclosure discloses an Indium Tin Oxide (ITO) thin film (200) for a terminal apparatus (800), the ITO thin film (200) comprises the patterns (101) configured to diffuse light (102), which can reduce thickness of the button region (301).

## Description

This application is based upon and claims priority to Chinese Patent Application 201310492710.6, filed on October, 18, 2013.

### TECHNICAL FIELD

The present disclosure generally relates to the field of electronic devices, and more particularly to an ITO thin film for a terminal apparatus.

### BACKGROUND

With the development of the electronic technology, terminal apparatus using touch screen have become very popular. Additionally, for the overall aesthetics of the terminal apparatus, physical buttons have been substituted with touch screen dedicated regions in the form of a touch button area.

In the related arts, Indium Tin Oxide (ITO) thin films are important to realize touch screen areas and touch button areas. The ITO thin film is a N-type semiconductor material with high conductivity, high visible light transmittance, high mechanical hardness and excellent chemical stability. Thus, ITO thin films are very common materials for Liquid Crystal Display (LCD), Plasma Display Panel (PDP), Electroluminescent Organic Light Emitting Diode (EL/OLED), Touch Panel, solar cell and transparent electrodes of other electronic instruments.

Touch button areas are generally dark when are not touched and lighted upon being touched. In general, a Light Guide Film (LGF) is necessary to balance the brightness of the buttons. The LGF is a product that can convert a point light source of a Light Emitting Diode (LED) into an illuminated area. The LGF has characteristics of ultra-thin, uniform luminance with various colors and may be used in the backlight of a mobile phone keypad.

ITO thin film and the LGF may be organized in a stacked configuration, increasing the thickness of the terminal apparatus.

### SUMMARY

In order to solve problems in the conventional art, the present disclosure provides an ITO thin film for a terminal apparatus in accordance with the claims which follow.

According to a first aspect of the embodiments of the present disclosure, an ITO thin film is provided and the ITO thin film includes patterns configured to diffuse light.

The ITO thin film and LGF can be combined together in the embodiments of the present disclosure with the aim to reduce the thickness of the touch button area.

The ITO thin film includes: an ITO layer, a light conducting material layer, and a polyethylene terephthalate (PET) layer. The ITO layer and the light conducting material layer are respectively attached to two sides of the PET layer, and the patterns are formed on the light conducting material layer.

The ITO layer and the light conducting material layer are attached to the same PET layer, as described in the embodiments of the present disclosure, resulting in a reduced thickness.

The ITO thin film includes an ITO layer and a PET layer.

Dots are provided on the side of the PET layer opposite to the ITO layer, and form the patterns.

Providing dots on the side of the PET layer may avoid the need to use the light conducting material and further reduce the thickness of the ITO thin film.

According to a second aspect of the embodiments of the present disclosure, a terminal apparatus is provided and the terminal apparatus includes: a touch panel; the touch panel includes a transparent cover plate, an ITO thin film and a LCD module; the touch panel is attached to the LCD module; and the ITO thin film is provided with patterns configured to diffuse light and is attached to the transparent cover plate, and the attaching position is located in a button region of the terminal apparatus.

Providing the ITO film with patterns configured to diffuse light in the button region of the terminal apparatus may reduce the thickness of the button region and make the button have improved effects of touching and displaying.

The distributions of the patterns on the buttons are denser than that on the positions other than the buttons.

The display uniformity of the light on the buttons is improved through the non-uniform distribution of the patterns.

The terminal apparatus further includes at least one light emitting element located in a side of an extending direction of the button region.

Further away the patterns are from the light emitting element, the denser the distributions of the patterns become.

The patterns are designed according to the positions of the light emitting elements, and therefore the display can be further improved.

The ITO thin film includes an ITO layer, a light conducting material layer, and a PET layer. The ITO layer and the light conducting material layer are respectively attached to two sides of the PET layer, and the patterns are formed on the light conducting material layer.

The ITO layer and the light conducting material layer are attached to the same layer in the embodiments of the present disclosure, this combination can further reduce the thickness.

The light conducting material layer is attached to the transparent cover plate.

The light conducting material layer is attached to the transparent cover plate in the embodiments of the present disclosure, which can facilitate the circuit design of the ITO layer.

The ITO thin film includes an ITO layer and a PET layer, and the PET layer is attached to the transparent cover plate.

Dots are provided on the side where the PET layer is attached to the transparent cover plate, and form the patterns.

The technical solutions provided by the embodiments of the present disclosure may include the following advantages:

On one hand, dots are provided on the side of the PET layer in the embodiments of the present disclosure, and may avoid the need to use the light conducting material and further reduce the thickness of the ITO thin film. The transparent cover plate can be a cover glass.

On the other hand, the transparency is good and the process is simple due to adopting the cover glass according to the embodiments of the present disclosure. The ITO thin film is located between the transparent cover plate and the LCD module.

The technical solutions provided by the embodiments of the present disclosure can improve the space utilization and decrease the thickness and length of the terminal apparatus.

### BRIEF DESCRIPTION OF THE DRAWINGS

The accompanying drawings, which are incorporated and constitute a part of this specification, illustrate embodiments consistent with the invention and, together with the description, serve to explain the principles of the invention.
Fig. 1A is a schematic view showing an ITO film according to an exemplary embodiment.
Fig. 1B is a schematic view showing a transmission of light according to an exemplary embodiment.
Fig. 2A is a first side sectional view showing an ITO film according to an exemplary embodiment.
Fig. 2B is a second side sectional view showing an ITO film according to an exemplary embodiment.
Fig. 3 is a first schematic view showing a terminal apparatus according to an exemplary embodiment.
Fig. 4A is a second schematic view showing a terminal apparatus according to an exemplary embodiment.
Fig. 4B is a third schematic view showing a terminal apparatus according to an exemplary embodiment.
Fig. 5 is a fourth schematic view showing a terminal apparatus according to an exemplary embodiment.
Fig. 6 is a first schematic view showing a pattern according to an exemplary embodiment.
Fig. 7 is a second schematic view showing a pattern according to an exemplary embodiment.
Fig. 8 is a block diagram of a terminal apparatus according to an exemplary embodiment.
Embodiments of the present disclosure that have been illustrated in the above drawings will be described in more detail hereinafter.

### DETAILED DESCRIPTION

The embodiments of the present disclosure will be further described in detail with reference to the accompanying drawings. Herein, the exemplary embodiments of the present disclosure and the description thereof intend to explain the present disclosure.

In the embodiments of the present disclosure, an ITO film and a LGF are combined together to reduce the thickness.

The ITO thin film is a N-type semiconductor material and is a PET-based film. The PET film is also referred as a polyester film with high-temperature resistance, which has excellent physical property, chemical property, dimensional stability, transparency and recyclability, and can be widely applied to the fields of magnetic recording, photographic materials, electronics, electrical insulation, industrial films, packaging decoration, etc. Moreover, a LGF is also a PET-based film. Thus, the ITO thin film and LGF can be combined together, so as to obtain the ITO film with patterns configured to diffuse light.

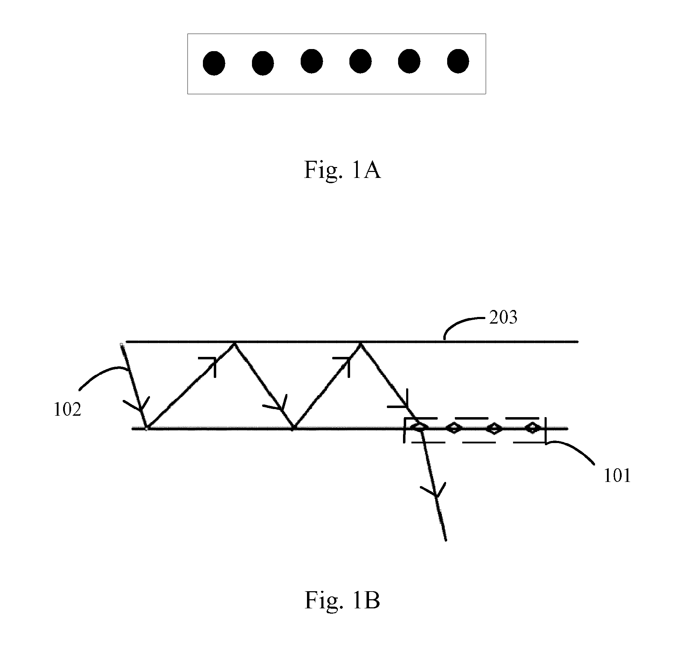

In an embodiment, as shown in Fig. 1A, the ITO film includes patterns configured to diffuse light. To clearly illustrate the patterns configured to diffuse light, the part of the ITO material is not shown in Fig. 1A.

In an embodiment, as shown in Fig. 1B, the ITO film includes a PET layer 203, on which patterns 101 for diffusing light is implemented. Albeit the PET layer 203 is very thin, it still has a thickness of about 0.1mm. Under illumination conditions, at least a part of light 102 is totally reflected within the PET layer 203. As shown in Fig. 1B, part of the light 102 is directly totally reflected by upper and lower surfaces of the PET layer 203. The angle of incidence of the light or the material density can be changed (i.e., to change a refractive index) when the light is needed to be emitted out from the PET layer 203. In this embodiment, a position from which the light is emitted out is the position where the patterns 101 are located. A way of changing the angle of incidence is by, for example, including concave points, or convex points, or both (hereinafter referred to as dots) on the surface of the PET layer 203, as long as the angle of incidence of the light 102 on the dots does not meet the condition of total reflection. A way of changing material density is by, for example, printing other materials on the surface of the PET layer 203 to form the patterns 101. As long as the density of the printed material is larger than the density of the material of the PET layer 203. The detailed structure of the ITO thin film can be understood through the following embodiments.

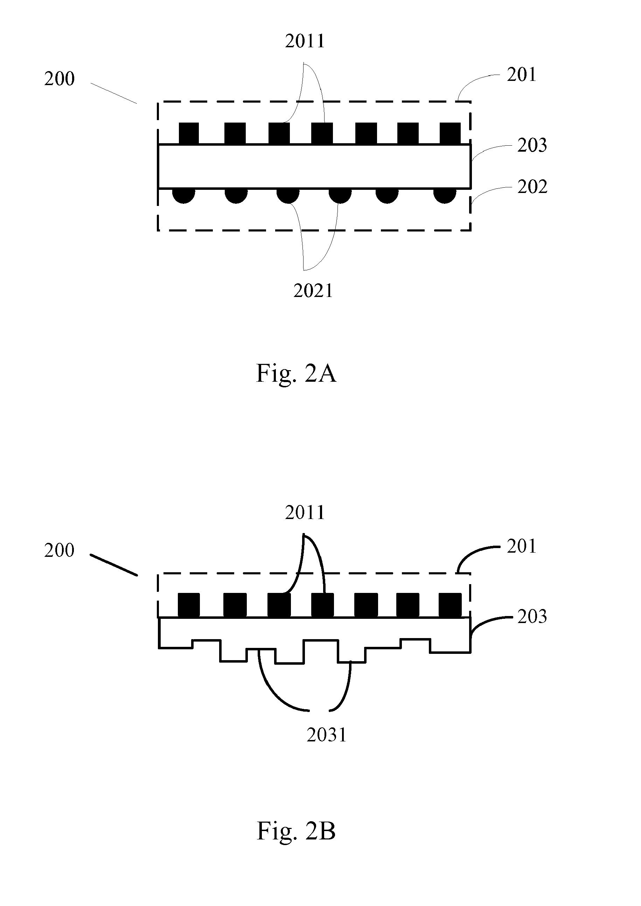

In an embodiment, as shown in Fig. 2A, the ITO film 200 includes: an ITO layer 201, a light conducting material layer 202 and a PET layer 203. The ITO layer 201 and the light conducting material layer 202 are respectively attached to two sides of the PET layer 203, and the patterns are provided on the light conducting material layer 202.

The ITO layer 201 comprises a plurality of transparent electrodes 2011 made from ITO materials. The shape and distribution of the transparent electrodes 2011 are related to the conductivity thereof, and can be designed as required.

The light conducting material layer 202 comprises a plurality of light conducting points 2021 made from light conducting materials. The patterns of respective light conducting points 2021 may be the same or different from each other; the distribution of respective light conducting points 2021 may be uniform or not; and the areas and shapes of each light conducting point 2021 may be varied accordingly. The light is totally reflected and diffused when hitting on the light conducting points 2021. The patterns are more densely distributed within the light conducting points 2021 and the light-conducting points 2021 are closer with each other, and thus more light is reflected. The materials of the light conducting points 2021 may be inks materials which do not absorb light, and thus a better effect of light reflecting can be obtained.

Polycarbonate (PC) or PMMA resin can be used as materials of the PET layer.

The ITO thin film in the present embodiment can be applied to the terminal apparatus to reduce the thickness thereof.

In one embodiment, as shown in Fig. 2B, the ITO film 200 includes the ITO layer 201 and the PET layer 203.

Dots 2031 are provided on the side of the PET layer 203 opposite to the ITO layer 201, and form a pattern configured to diffuse light.

Providing dots on the side of the PET layer, may avoid the need to use the light conducting material and further reduce the thickness of the ITO thin film.

The shapes of dots are not limited to square, circle or other shapes. The sizes of respective dots may be the same or different from each other. The heights of dots are related to the reflection effect and can be determined depending on the actual needs. The concavity of the concave points and the convexity of the convex points may be a plane, a curved surface or a v-shaped surface, etc.

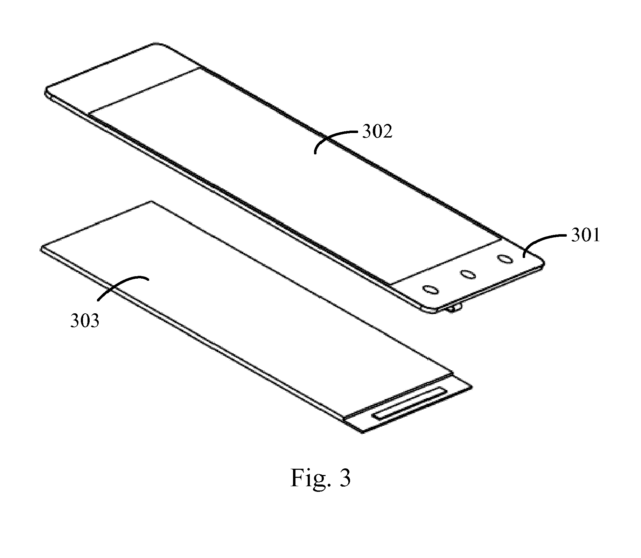

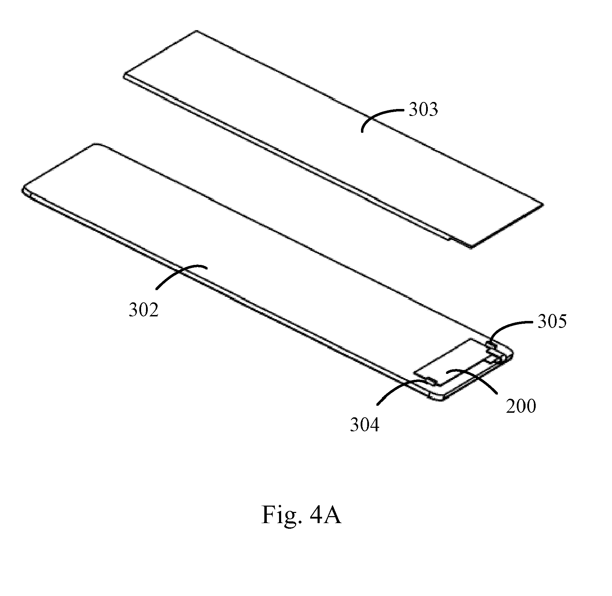

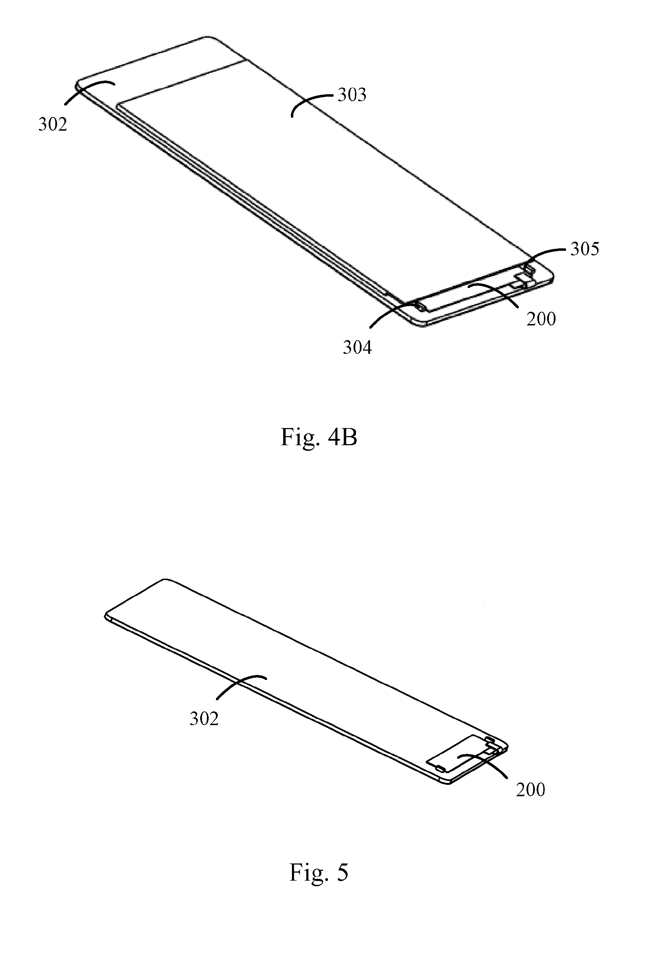

In an embodiment, as shown in Fig. 3, Fig. 4A and Fig. 4B, the terminal apparatus includes a touch panel.

The touch panel includes a transparent cover plate 302, an ITO thin film 200 and a LCD module 302.

The transparent cover plate 302 is attached to the LCD module 303. The LCD module 303 includes a display region and a drive region, and the display region of the LCD module 303 is attached to the transparent cover plate 302. There is a gap between the drive region of the LCD module 303 and the transparent cover plate 302 due to the different thicknesses of the display region and the drive region of the LCD module 303. The drive region of the LCD module 303 is located in a button region 301.

The ITO thin film 200 has patterns configured to diffuse light and is attached to the transparent cover plate 302, and the attaching position is in the button region 301 of the terminal apparatus.

The button region 301 includes icons of function buttons, such as a menu button, a back button and a home button and the like. The menu button, the back button and the home button can be realized through the transparent electrode 2011 included in the ITO film 200.

The ITO thin film with patterns configured to diffuse light is provided in the button region of the terminal apparatus, as result it may reduce the thickness of the button region, make the buttons have good touching responses, and promote displaying of information.

The combination of the ITO thin film and the LGF, if they are used, cannot be provided in the gap between the drive region of the LCD module 303 and the transparent cover plate 302 due its large thickness. Therefore, the ITO thin film cannot be used in the button region 301. However, in the present embodiment, the ITO thin film is very thin, and having combined properties of the ITO thin film and LGF, it can be used in the gap between the drive region of the LCD module 303 and the transparent cover plate 302, and thereby can be applied in the button region 301.

As shown in Fig. 5, the ITO thin film 200 is attached to the transparent cover plate 302, so that the position of the ITO thin film can be easily fixed.

The transparent cover plate 302 may be a cover glass with good transparency and hardness.

As shown in Fig. 2A, if the ITO thin film includes the light conducting material layer 202, the light conducting material layer 202 is attached to the transparent cover plate 302 so as to facilitate the circuit design of the ITO layer.

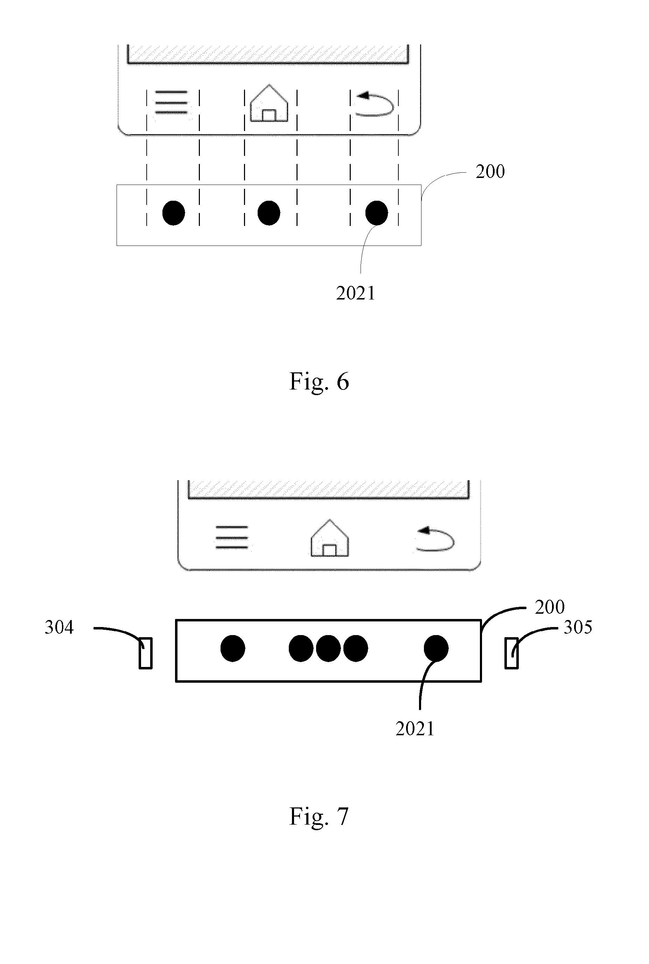

As shown in Fig. 6, in the button region 301, the distributions of the patterns on the ITO thin film 200 are denser than that on the positions other than the buttons, as result it may be improved the display uniformity of the light on the buttons.

As shown in Fig. 2B, if the ITO thin film 200 does not include the light conducting material layer 202, the PET layer 203 is attached to the transparent cover plate 302. The dots are provided on the side where the PET layer 203 is attached to the transparent cover plate 302, and form the patterns. In the button region 301, the distributions of the dots are denser than that on the positions other than the buttons, as result it may be improved the display uniformity of the light on the buttons.

As shown in Fig. 4B, the terminal apparatus further includes at least one light emitting element located on a side of the button region 301. Two light emitting elements 304 and 305 are taken as examples in the present embodiment, they are located on two sides of the extending direction of the button region 301. The light emitting elements 304 and 305 may be a light emitting diode (LED), etc. The light emitting elements 304 and 305 may be attached on the ITO thin film 200 so as to light the button region 301, reducing the cost of the manufacturing process.

The farther away the patterns on the ITO film 200 are from the light emitting elements 304 and 305, the denser become the distributions of the patterns on the ITO film 200, further improving the display effect. The patterns on the ITO thin film 200 are shown in Fig. 7.

The PET layer 203 may use colored materials to realize the color effect of the buttons.

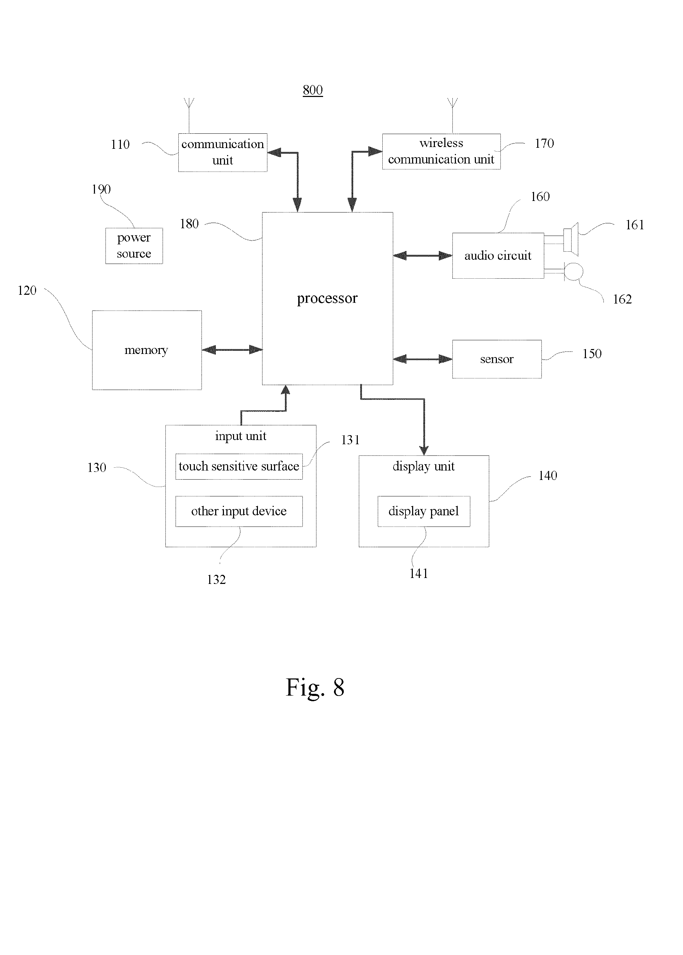

Fig. 8 is a block diagram of a terminal apparatus (which may be the request terminal or the associated terminal) according to an exemplary embodiment.

The terminal apparatus 800 may include: a communication unit 110, a memory 120 including one or more computer readable storage media, an input unit 130, a display unit 140, a sensor 150, an audio circuit 160, a wireless communication unit 170, a processor 180 including one or more process cores, and a power source 190 and the like. Those skilled in the art may understand that the terminal apparatus is not limited to the structure of the terminal apparatus as shown in this figure, and it may include more or less components, or a combination of some components, or different component arrangements.

The communication unit 110 may be configured to transmit and receive signals during transmitting and receiving of information or a process of calling. The communication unit 110 may be a network communication device such as a Radio Frequency (RF) circuit, a router, a modem and the like. In particular, if the communication unit 110 is the RF circuit, the communication unit 110 receives downlink information from a base station and then transmits the information to the one or more processors 180 to be processed, and transmits the related uplink data to the base station. Generally, the RF circuit served as the communication unit includes, but is not limited to, an antenna, at least one amplifier, a tuner, one or more oscillators, a Subscriber Identity Module (SIM) card, a transceiver, a coupler, a Low Noise Amplifier (LNA), a duplexer and the like. Additionally, the communication unit 110 may also communicate with a network or other devices via a wireless network. The wireless network may adopt any one of communication standard or protocol including, but not limited to, Global System of Mobile communication (GSM), General Packet Radio Service (GPRS), Code Division Multiple Access (CDMA), Wideband Code Division Multiple Access (WCDMA), Long Term Evolution (LTE), email, Short Messaging Service (SMS) and the like. The memory 120 may be configured to store programs and modules software programs and modules, which allow various types of functional applications and data processes to be performed when executed by the processor 180. The memory 120 may mainly include a program storage area and a data storage area. The program storage area may store an operating system, applications required by at least one required functions (such as voice play function, image play function and the like). The data storage area may store data (such as video data, phonebook data, and the like) created by the use of the terminal apparatus 800. Besides, the memory 120 may include a high speed random access memory. The memory 120 may also include a nonvolatile memory (NVM), such as at least a magnetic disk storage device, flash memory or other nonvolatile solid-state storage device. Additionally, the memory 120 may also include a memory controller to control access to the memory 120 performed by the processor 180 and the input unit 130.

The input unit 130 may be configured to receive input numerical or character information and generate signal inputs related to user settings and function control through a keypad, a mouse, an operation rod, and an optical device or trackball. Optionally, the input unit 130 may include a touch sensitive surface 131 and other input devices 132. The touch sensitive surface 131, or a touch display screen or a track pad, may collect touch operation on it or near it performed by the user (for example the user operations on or near the touch sensitive surface 131 with any kind of suitable objects or attachments such as a finger, a touch pen, and the like), and drive the corresponding connection device according to a preset program. Optionally, the touch sensitive surface 131 may include two parts, i.e., a touch detecting device and a touch controller. The touch detecting device may detect the touch orientation of the user, and detect the signal caused by the touch operation, and then transmit the signal to the touch controller. The touch controller may receive the touch information from the touch detecting device and convert it into touch point coordinates and then transmit the coordinates to the processor 180. The touch controller also receives and performs instructions from the processor 180. Additionally, the touch sensitive surface 131 may be realized with various types such as resistive, capacitive, infrared, or surface acoustic wave and the like. The input unit 130 may also include other kind of input device 132 besides the input unit 130. Optionally, the other input device 132 may include, without limitation, one or more of a physical keypad, functional buttons (such as volume control button, switch button and the like), a trackball, a mouse, an operating rod and the like.

The display unit 140 may be configured to display various information input by the user or provided to the user from the terminal apparatus 800. These graphic information may be made up of graphics, texts, icons, videos and any other combination thereof. The display unit 140 may include a display panel 141, optionally, LCD (Liquid Crystal Display), OLED (Organic Light-Emitting Diode) or the like. Furthermore, the touch sensitive surface 131 may be configured to cover the display panel 141. When detecting the touch operation performed on or near the touch sensitive surface 131, the touch sensitive surface 131 may transmit signals to the processor 180 to determine the type of the touch event, and then the processor 180 may provide a corresponding visual output on the display panel 141 according to the type of the touch event. Although in Fig. 8 the touch sensitive surface 131 and the display panel 141 are configured to realize the input and output functions as two independent components, they can be integrated together in some embodiment to realize the input and output functions.

The terminal apparatus 800 may also include at least one sensor 150 such as a photo sensor, a motion sensor and other sensors. For example, the photo sensor may include an ambient light sensor and a proximity sensor. The ambient light sensor may adjust brightness of the display panel 141 according to the intensity of the ambient light. The proximity sensor may close the display panel and/or backlight when the terminal apparatus 800 is close to the user's ear. As one type of motion sensors, a gravitational acceleration sensor may detect values of accelerations in various directions (usually three axes); may detect a value and a direction of the gravitation when resting; and may be used in an application for identifying a mobile phone pose (such as switching between a landscape mode and a vertical mode, corresponding games, pose adjusting with a magnetometer), functions related to vibration (such as a pedometer, knocking) and the like. Other sensors such as a gyroscope, a barometer, an hygrometer, a thermometer, an infrared sensor and the like which may be arranged in the terminal apparatus 800 will not be described in detailed.

The audio circuit 160, the speaker 161, and the microphone 162 may provide an audio interface between the user and the terminal apparatus 800. The audio circuit 160 may convert the received audio data into electronic signals and transmit the electronic signals to the speaker 161, and the speaker 161 may convert the electronic signals into voice and output the voice. Additionally, the microphone 162 may convert the collected voice signals into electronic signals; the audio circuit 160 receives the electronic signals and converts them into audio data; and the audio data is transmitted to the processor 180 and then is transmitted to another terminal device via the RF circuit 110 after processed by the processor; or the audio data is transmitted to the memory 120 to be further processed. The audio circuit 160 may also include an earplug jack to allow communication between a peripheral earphone and the terminal apparatus 800.

In order to achieve wireless communication, the terminal apparatus may be provided with the wireless communication unit 170 which may be a WIFI module. WIFI is a short-range wireless transmission technology. The terminal apparatus 800 may help the user transmit or receive E-mail, browse web pages and access streaming media and the like through the wireless communication unit 170, which provides the user the wireless broadband internet access. Although the wireless communication unit 170 is shown in the drawings, it should be understood that the wireless communication unit 170 is not a necessary component of the terminal apparatus 800, and may be omitted according to requirements within the scope without changing the substance of the present disclosure.

The processor 180 is a control center of the terminal apparatus 800 and may use various interfaces and wires to connect respective portions of the whole client computer. By running or executing software programs and/or modules stored in the memory 120, calling data stored in the memory 120, and executing various functions of the terminal apparatus 800 and processing data, the processor 180 proceeds overall monitoring to the terminal apparatus. Optionally, the processor 180 may include one or more processing cores. Optionally, the processor 180 may integrate application processors and modem processors, wherein the application processors may mainly process the operation systems, the user interfaces, the application programs and the like, and the modem processors may mainly process wireless communications. It should be understood that the above modem may not be integrated into the processor 180.

The terminal apparatus 800 may also include the power supply 190 (for example, a battery) to supply power to respective component. Optionally, the power supply may be logically connected with the processor 180 through a power supply management system, thereby realizing functions of managing charging, discharging, power consumption, and through the power supply management system. The power supply 190 may further include arbitrary components such as one or more DC or AC power supplies, a rechargeable system, a power supply malfunction detection circuit, a power supply converter or an inverter, a power supply state indicator and the like.

Although not shown, the terminal apparatus 800 may also include a camera, a Bluetooth module, which will not be described in detail.

The terminal apparatus 800 includes an ITO thin film with patterns configured to diffuse light, and the ITO thin film is located in the button region of the terminal apparatus.

In the button region, the distributions of the patterns on buttons are denser than that on the positions other than the buttons.

The terminal apparatus 800 also includes at least one light emitting element which is located in a side of an extending direction of the button region.

Further away the patterns are from the light emitting element, the denser is the distributions of the patterns.

The ITO thin film includes an ITO layer, a light conducting material layer and a PET layer, the ITO layer and the light conducting material layer are respectively attached to two sides of the PET layer, and the patterns are formed on the light conducting material layer.

The terminal apparatus also includes a cover glass, and the ITO thin film is attached to the cover glass.

The light conducting material layer is attached to the cover glass.

The terminal apparatus also includes a LCD module, and the ITO thin film is provided between the cover glass and the LCD module.

In addition, the mobile terminal described in the present disclosure may be any handheld mobile terminal, such as mobile phone, a personal digital assistants (PDA).

## Claims

1. An Indium Tin Oxide (ITO) thin film (200), wherein the ITO thin film (200) comprises patterns configured to diffuse light.

2. The ITO thin film of claim 1, wherein the ITO thin film (200) comprises an ITO layer (201), a light conducting material layer (202), and a Polyethylene Terephthalate (PET) layer (203); wherein the ITO layer (201) and the light conducting material layer configured to respectively attach to two sides of the PET layer (203), and the patterns are formed on the light conducting material layer.

3. The ITO thin film of claim 1, wherein the ITO thin film (200) comprises an ITO layer (201) and a PET layer (203).

4. A terminal apparatus (800) comprising a touch panel attached to an Liquid Crystal Display (LCD) module (303);
wherein the touch panel comprises a transparent cover plate (302), an ITO thin film (200) and the LCD module (303); wherein the ITO thin film (200) is provided with patterns configured to diffuse light and is attached to the transparent cover plate (302), and the attaching position is located in a button region (301) of the terminal apparatus (800).

5. The terminal apparatus (800) according to claim 4, wherein distributions of the patterns on buttons are denser than on positions other than the buttons.

6. The terminal apparatus (800) according to claim 4, wherein the terminal apparatus (800) further comprises:
at least one light emitting element (304, 305) configured to be located in a side of an extending direction of the button region (301); and
wherein distributions of the patterns become denser the further away the patterns are from the light emitting element (304, 305).

7. The terminal apparatus (800) according to claim 4, wherein the ITO thin film (200) comprises:
an ITO layer (201);
a light conducting material layer;
a PET layer (203); and
wherein the ITO layer (201) and the light conducting material layer are respectively attached to two sides of the PET layer (203), and the patterns are formed on the light conducting material layer.

8. The terminal apparatus (800) according to claim 7, wherein the light conducting material layer is attached to the transparent cover plate (302).

9. The terminal apparatus (800) according to claim 4, wherein the ITO thin film (200) comprises an ITO layer (201) and a PET layer (203), and the PET layer (203) is attached to the transparent cover plate (302); and
dots are provided on one side where the PET layer (203) is attached to the transparent cover plate (302), and configured to form the patterns.

10. The terminal apparatus (800) according to claim 4, wherein the transparent cover plate (302) is a cover glass.

11. The terminal apparatus (800) according to claim 4, **characterized in that**, the ITO thin film (200) is located between the transparent cover plate (302) and the LCD module (303).
